(19) Europäisches Patentamt / European Patent Office / Office européen des brevets

(11) **EP 1 791 191 A1**

(12) **EUROPEAN PATENT APPLICATION**
published in accordance with Art. 158(3) EPC

(43) Date of publication:
**30.05.2007 Bulletin 2007/22**

(51) Int Cl.:
*H01L 35/22* (2006.01)     *C04B 35/46* (2006.01)
*C04B 41/87* (2006.01)     *H01L 35/34* (2006.01)

(21) Application number: **05767817.9**

(22) Date of filing: **22.07.2005**

(86) International application number:
**PCT/JP2005/013897**

(87) International publication number:
**WO 2006/011581 (02.02.2006 Gazette 2006/05)**

(84) Designated Contracting States:
**DE FR**

(30) Priority: **27.07.2004 JP 2004218387**
**30.09.2004 JP 2004286811**

(71) Applicant: **Sumitomo Chemical Company, Limited**
**Tokyo 104-8260 (JP)**

(72) Inventors:
• **UCHIDA, Yoshio**
**Tsukuba-shi, Ibaraki 3050045 (JP)**
• **TOHMA, Tetsuro**
**Tsukuba-shi, Ibaraki 3050821 (JP)**

(74) Representative: **Vossius & Partner**
**Siebertstrasse 4**
**81675 München (DE)**

(54) **THERMOELECTRIC CONVERSION MATERIAL AND PROCESS FOR PRODUCING THE SAME**

(57)    The present invention provides a thermoelectric conversion material and a process for producing the thermoelectric conversion materials. The thermoelectric conversion material I comprises a titanium oxide represented by the formula (A) $TiO_x$
(A), wherein $1.89 = x < 1.94$ or $1.94 < x < 2.00$, and the n-type thermoelectric conversion material has peaks at positions of $2\theta = 26.0° \pm 0.3°$, $26.8° \pm 0.3°$, $27.9° \pm 0.1°$, and $28.2° \pm 0.1°$ in an X-ray diffraction pattern measured under the conditions: X-ray source: CuKa, tube current: 140 mA, tube voltage: 40 kV, and step width: 0.02°. The process for producing a n-type thermoelectric conversion material I comprises the steps of calcining a titanium compound in a hydrogen-containing atmosphere under the following conditions to obtain a powder, in case of a hydrogen concentration of not less than 1 vol % and less than 5 vol % (balance inert gas): Calcination Temperature: 1000°C to 1400°C, Calcination Time: 1 hr to 10 hours, in case of a hydrogen concentration of not less than 5 vol % and not more than 100 vol % (balance inert gas) : Calcination Temperature: 950°C to 1050°C, Calcination Time: 10 min to 5 hours, molding the powder, and sintering the resultant.

**Fig. 1**

: Ba

: TiO6

EP 1 791 191 A1

EP 1 791 191 A1

**Description**

**TECHNICAL FIELD**

The present invention relates to a thermoelectric conversion material. More particularly, the invention relates to a n-type thermoelectric conversion material.

**BACKGROUND ART**

Thermoelectric conversion power generation system refers to electric power generation system produced by converting thermal energy directly to electric energy. Thermoelectric conversion is based on the Seebeck effect that is the conversion of temperature differences directly into electric voltage called thermoelectromotive force in a thermoelectric conversion material. So thermoelectric conversion power generation system can recover waste heat from incinerators and so on as electric power. Furthermore, unlike conventional power generators, thermoelectric power generation system has the advantage that there is no moving parts, and it does not induce any pollutions. In these terms, thermoelectric power generation system is suitable for practical and continuous use without frequent maintenance and is expected to be an environmentally friendly power generation technology.

The energy conversion efficiency of a thermoelectric conversion material depends on the figure of merit (Z) of the material. The figure of merit (Z) is expressed by the following equation (1) and it is assumed that the higher the figure of merit (Z) of thermoelectric conversion material is, the higher their energy conversion efficiency is:

$$Z = a^2 \times s / K \qquad (1)$$

where a is a Seebeck coefficient, s is an electric conductivity, and K is a thermal conductivity.

Thermoelectric conversion material includes p-type thermoelectric conversion material having positive Seebeck coefficients and n-type thermoelectric conversion material having negative Seebeck coefficients. Thermoelectric modules include thermoelectric conversion elements in which the p-type and n-type thermoelectric conversion materials are connected electrically in series and thermally in parallel with each other. Since the energy conversion efficiency of the thermoelectric conversion elements depends on the p-type and n-type thermoelectric conversion materials, both the p-type and n-type thermoelectric conversion materials are required to have high figure of merits.

As n-type thermoelectric conversion material, the use of metallic oxides has been under study, and therefore, for example, titanium oxides such as $TiO_{1.94}$, $TiO_{1.88}$, and $TiO_{1.95}$ (see Study Report by the Nissan Chemical Industries Development Foundation, 2003, Vol. 26) and titanate such as $SrTiO_3$ with a perovskite-type crystal structure, $Sr_2TiO_4$ with a $K_2NiF_4$-type crystal structure, and $Sr_3Ti_2O_7$ with a $Sr_3Ti_2O_7$-type crystal structure (JP-A No. 8-231223) have been proposed.

**DISCLOSURE OF THE INVENTION**

An object of the present invention is to provide a high-performance n-type thermoelectric conversion material. The present inventors conducted extensive studies on n-type thermoelectric conversion material and as a result of that, the present invention has been accomplished.

That is, the present invention provides a n-type thermoelectric conversion material comprising a titanium oxide represented by the formula (A)

$$TiO_x \qquad (A)$$

wherein $1.89 = x < 1.94$ or $1.94 < x < 2.00$, and the n-type thermoelectric conversion material has peaks at positions of $2\theta = 26.0° \pm 0.3°$, $26.8° \pm 0.3°$, $27.9° \pm 0.1°$, and $28.2° \pm 0.1°$ in an X-ray diffraction pattern measured under the following conditions:

X-ray source: CuKa,
tube current: 140 mA,
tube voltage: 40 kV, and
step width: 0.02°.

The invention provides a process for producing a n-type thermoelectric conversion material comprising the steps of: calcining a titanium compound in a hydrogen-containing atmosphere under the following conditions to obtain a powder,
in case of a hydrogen concentration of not less than 1 vol % and less than 5 vol % (balance inert gas):
Calcination Temperature: 1000°C to 1400°C,
Calcination Time: 1 hr to 10 hours,
in case of a hydrogen concentration of not less than 5 vol % and not more than 100 vol % (balance inert gas):
Calcination temperature: 950°C to 1050°C,
Calcination time: 10 min to 5 hours,
molding the powder, and,
sintering the resultant.

Further, the invention provides a n-type thermoelectric conversion material comprising a compound containing an alkaline earth metal, a titanium, and an oxygen, wherein at least one part of the titanium are ions of trivalent titanium, and the following conditions (a) to (c) are satisfied:

(a) the molar ratio of titanium (Ti) to the alkaline earth metal (Ae) is not less than 2,
(b) the [TiO6] octahedrons in which six oxygen ions coordinated octahedrally surrounding titanium ion share their vertices and/or edges, and/or faces with each other, and form one-dimensional chain.
(c) the one-dimensional chains gather in the units of at least four pieces with part of the vertices of the octahedrons shared such that the compound is contained which has a one-dimensional tunnel-type crystal structure in which tunnel spaces surrounded by the at least four chains are formed.

Furthermore, the invention provides a process for producing a n-type thermoelectric conversion material comprising the steps of:

calcining a titanium compound and an alkaline earth metal compound in a reducing atmosphere at a temperature of 600° C to 1100°C to obtains a powder,
molding the powder, and
sintering the resultant in an inert gas atmosphere or a reducing atmosphere at a temperature of 1100°C to 1700°C.

According to the present invention, a n-type thermoelectric conversion material is provided which is suitable for thermoelectric power generation system. The n-type thermoelectric conversion material converts thermal energy efficiently to electric power. Further, according to the producing process of the invention, these n-type thermoelectric conversion materials can be easily produced.

## BRIEF DESCRIPTION OF THE DRAWINGS

Fig. 1 shows an example of a hollandite crystal structure.
Fig. 2 shows an X-ray diffraction pattern of a sintered body of Example 4.
Fig. 3 shows the temperature dependence of the Seebeck coefficient of the sintered body of Example 4.
Fig. 4 shows the temperature dependence of the electric conductivity of the sintered body of Example 4.
Fig. 5 shows the temperature dependence of the thermal conductivity of the sintered body of Example 4.
Fig. 6 shows the temperature dependence of the figure of merits Z of the sintered body of Examples 4, 10, and 12.

## BEST MODE FOR CARRYING OUT THE INVENTION

### N-TYPE THERMOELECTRIC CONVERSION MATERIAL I

A n-type thermoelectric conversion material I according to the present invention is a titanium oxide having a ratio of oxygen to titanium of less than 2 (nonstoichiometric titanium oxide) and which is represented by the above formula (A) in which 1.89=x<1.94 or 1.94<x<2.00, preferably 1.92=x=1.93 or 1.96=x=1.98, and much preferably 1.92=x=1.93.

The n-type thermoelectric conversion material I has no Magneli phase and therefore differs from conventional nonstoichiometric titanium oxide in view of crystal structure. The n-type thermoelectric conversion material I has peaks at positions of $2\theta=26.0°\pm0.3°$, $26.8°\pm0.3°$, $27.9°\pm0.1°$, and $28.2°\pm0.1°$ in an X-ray diffraction pattern. In this specification, the phrase "have a peak at a position of $2\theta=26.0°\pm0.3°$ "means that the peak is present in the range of from 25.7° to 26.3°. The X-ray diffraction pattern may be measured under the following conditions:

X-ray source: Cuka;
tube current: 140 mA;
tube voltage: 40 kV; and
step width: 0.02°.

On the other hand, n-type thermoelectric conversion materials I with Magneli phases have high thermal conductivity and low figure of merits Z even if they satisfy the above formula (A).

The n-type thermoelectric conversion material I may contain elements other than titanium and oxygen. Examples of such elements include alkaline metals (Li, Na, and K), alkaline earth metal (Mg, Ca, Sr, Ba), rare earth metal (Y, La, Ce), group IV metal (Zr, Hf), group V metal (V), group VI metal (Cr, Mo), group VII metal (Mn), group XIV metal (Sn), and group XV metal (Bi).

When the n-type thermoelectric conversion material I includes the alkaline metal or the alkaline earth metal, the alkaline (earth) metal may usually substitute the lattice points near oxygen defects or include as interstitial ions in the crystal. Such a n-type thermoelectric conversion material I containing the alkaline (earth) metal has a low thermal conductivity and a high figure of merit Z. The amount of the alkaline (earth) metal may be within a range in which the n-type thermoelectric conversion material I has the foregoing X-ray diffraction pattern (retains a crystal structure determined by means of X-ray diffraction) and is, therefore, for example, not less than 1 ppm by weight and not more than 5 % by weight.

When the n-type thermoelectric conversion material I contains the rare earth metal or the group IV metal, the metal may be substituted with titanium in the crystal. Such a n-type thermoelectric conversion material I containing the rare earth metal or the group IV metal has a low thermal conductivity and a high figure of merit Z. The amount of the rare earth metal or the group IV metal can be within the range in which the n-type thermoelectric conversion material I has the foregoing X-ray diffraction pattern (retains the crystal structure determined by means of X-ray diffraction) and is, therefore, for example, not less than 1 ppm by weight and not more than 5 % by weight.

When the n-type thermoelectric conversion material I contains the group V metal, the group VI metal, the group VII metal, the group XII metal, or the group XIII metal, the amount of the metal contained therein is, for example, not less than 1 ppm by weight and not more than 5 % by weight.

The n-type thermoelectric conversion material I is typically used in the form of a sintered body. The sintered body has a density of about not less than 1.7 $g/cm^3$ (the relative density thereof to the theoretical density of $TiO_2$ of 4.25$g/cm^3$ is about not less than 40 %), preferably not less than 1. 9 $g/cm^3$ (about not less than 45 %), more preferably about not less than 2.1 $g/cm^3$ (about not less than 50 %), and further preferably about not less than 2.6 $g/cm^3$ (about not less than 60 %). It is preferable that the particle diameter of the sintered body is smaller, and therefore the particle diameter is about not more than 10 $\mu$m. The lower limit of the particle diameter is usually about 0.1 $\mu$m.

The n-type thermoelectric conversion material I may have an over coating layer which is formed as a surface layer. The over coating layer may intercept oxygen penetration, and hence examples of the layer include an alumina layer, a titania layer, a zirconia layer, and a silicon carbide layer. Even when the n-type thermoelectric conversion material I with the over coating layer has been exposed to a high temperature (for example, 1000°C), the oxidation of trivalent titanium (from trivalent titanium to quadrivalent titanium) contained in the n-type thermoelectric conversion material I is suppressed and as a result of this, high performance is maintained.

It is preferable that the n-type thermoelectric conversion material I is used at a temperature of not more than 400°C. When used at a temperature of more than 400°C, there is a possibility that its performance deteriorates because trivalent Ti contained in the n-type thermoelectric conversion material I is oxidized (in a case where the over layer is not provided in particular).

A thermoelectric conversion module contains the foregoing n-type thermoelectric conversion material I and a p-type thermoelectric conversion material. As the p-type thermoelectric conversion material, known material may be used.

The thermoelectric conversion module is usually placed in the enclosure of a thermoelectric conversion power generation unit. The enclosure of the unit may be vacuum-sealed or sealed with an inert gas (nitrogen, argon, helium, or the like) filled.

Thermoelectric conversion power generation systems usually contain the foregoing thermoelectric conversion power generation unit and a control unit. The control unit regulates the amount of power generation produced by the thermoelectric conversion power generation unit.

## PROCESS FOR PRODUCING N-TYPE THERMOELECTRIC CONVERSION MATERIAL I

The n-type thermoelectric conversion material I may be produced by using a process in which, for example, a titanium compound is calcined in a hydrogen-containing atmosphere.

As the titanium compound, material converted to titanium oxide by calcination (for example titanyl sulfate and the like) or titania ($TiO_2$) is used; titania is preferably used. The titania has a crystal structure of rutile, anatase, or brookite.

Calcination is carried out in a reducing atmosphere. The reducing atmosphere is produced by using, for example, an inert gas (nitrogen, argon, helium, or the like) containing at least 1 vol % of hydrogen. By calcination in the reducing atmosphere, a calcined product represented by the formula (A) is obtained. Calcination conditions depend on the concentration of the hydrogen gas contained in the atmosphere and are, for example, as follows:

in a case where the hydrogen concentration is not less than 1 vol % and less than 5 vol % (balance inert gas),
Calcination Temperature: 1000°C to 1400°C,
Calcination Time: 1 hour to 10 hours,
in a case where the hydrogen concentration is not less than 5 vol % and not more than 100 vol (balance inert gas),
Calcination temperature: 950°C to 1050°C,
Calcination time: 10 minutes to 5 hours.
In either case, it is preferable to keep a calcined product in the reducing condition until the temperature is lowered to room temperature after the calcination. Calcined products may be pulverized. The pulverization may be carried out by using a ball mill, a vibration mill, an attritor, a dynor mill, or the like. By changing the grain size of the pulverized powders, sintered bodies with different densities may be obtained at the sintering step as set forth below.

The powder is usually molded before the sintering. The molding may be carried out by using, for example, uniaxial pressing, cold isostatic pressing (CIP), mechanical pressing, or the like. The powder is molded so as to have the shape of a prism, a cylinder, or the like in accordance with the shape of the thermoelectric conversion module. By changing molding pressure, sintered bodies with different densities may be obtained.

Further, in this molding, spray drying may be combined therewith. Spherical particles having a diameter of several tens of $\mu$m are prepared by using spray drying. The spherical particles are molded, and then sintered as set forth below to obtain a sintered body having a controlled density.

Furthermore, in the molding, substances to be lost during the sintering (for example, resin beads or walnut powder) may be mixed with the powder. By mixing the substance to be lost during the sintering therewith, sintered bodies with different pore size are obtained at the sintering step set forth below.

The obtained green body is usually sintered. The sintering is usually carried out in an atmosphere of an inert gas (nitrogen, argon, helium, or the like) containing at least 1 vol % of hydrogen. A sintering temperature and sintering time may be the same as those set at the calcination step described above. By changing the sintering temperature and the sintering time, it is possible to control the density and pore size of the sintered body.

The resulting sintered body may be annealed in air. Annealing may be carried out at a temperature in the range of , for example, 600° C to 1000° C. By annealing the sintered body, the durability of the n-type thermoelectric conversion material I may be improved. After annealing in air, the over coating layer made of alumina, titania, zirconia, or silicon carbide may be formed on the n-type thermoelectric conversion material I by using, for example, aerosol deposition, flame spraying, or the like.

Furthermore, the n-type thermoelectric conversion material I may be produced by using a method in which a titanium compound is molded to obtain a green body and the green body is sintered in a hydrogen-containing atmosphere.

Examples of the titanium compound include materials converted to titanium oxide by calcining (titanyl sulfate and so on) and titania, preferably titania. The titania has a crystal structure of rutile, anatase or brookite.

Molding may be carried out by, for example, uniaxial pressing, cold isostatic pressing (CIP), mechanical pressing, or the like; and besides spray drying may be combined.

In addition, sintering is carried out in a reducing atmosphere. The reducing atmosphere is produced by using, for example, an inert gas (nitrogen, argon, helium, or the like) containing at least 1 vol % of hydrogen. Sintering conditions depend on the concentration of the hydrogen gas contained in the atmosphere and are, for example, as follows:

in a case where the hydrogen concentration is not less than 1 vol % and less than 5 vol % (balance inert gas),
Sintering temperature: 1000°C to 1400°C,
Sintering time: 1 hour to 10 hours,
in a case where the hydrogen concentration is not less than 5 vol % and not more than 100 vol % (balance inert gas),
Sintering temperature: 950°C to 1050°C,
Sintering time: 10 minutes to 5 hours.
In either case, it is preferable to keep a sintered body in the reducing atmosphere until the temperature is lowered to room after the sintering.
The resulting sintered body may be annealed in air. The annealing may be carried out at a temperature of, for example, 600°C to 1000°C. Furthermore, on the sintered body, an over coating layer made of alumina, titania, zirconia, or silicon carbide may be formed by means of aerosol deposition, flame spraying, or the like.

N-TYPE THERMOELECTRIC CONVERSION MATERIAL II

A n-type thermoelectric conversion material II according to the present invention contains a compound having an alkaline earth metal, a titanium, and an oxygen.

The alkaline earth metal is calcium (Ca), strontium (Sr), or barium (Ba). The alkaline earth metal is used alone or in combination thereof, preferably in combinations of the two kinds or more. The n-type thermoelectric conversion material II having at least two kinds of alkaline earth metals has a low thermal conductivity and a high figure of merit Z. The molar ratio Ti/Ae of titanium (Ti) to the alkaline earth metal (referred to Ae) is not less than 2. The molar ratio Ti/Ae is preferably not less than 3 and usually not more than 20.

Further, the n-type thermoelectric conversion material II contains preferably at least one selected from the group consisting of $Ae_2Ti_{13}O_{22}$, $Ae_yTi_8O_{16}$ (y is from 0.8 to 2), $AeTi_7O_{14}$, and $Ae_2Ti_6O_{13}$, more preferably $Ae_yTi_8O_{16}$ (y is from 0.8 to 2).

Furthermore, the n-type thermoelectric conversion material II may have a ratio of trivalent titanium ions to all the titanium atoms of not less than 10 %. When the ratio of the trivalent titanium ions is low, the electric conductivity of the n-type thermoelectric conversion material may deteriorate and as a result its figure of merit may also deteriorate. Moreover, although all the titanium atoms may be the trivalent titanium ions, the upper limit of the ratio of the trivalent titanium ions is preferably 50 %. For example, when the compound $Ae_2Ti_{13}O_{22}$ is contained, the ratio of the trivalent titanium ions to all the titanium atoms is 92 %; when the compound $Ae_yTi_8O_{16}$ (y is from 0.8 to 2) is contained, the ratios are 20 % (y is 0.8) and 50 % (y is 2); when the compound $AeTi_7O_{14}$ is contained, the ratio is 29 %; and when the compound $Ae_2Ti_6O_{13}$ is contained, the ratio is 33 %. In addition, in applications where low temperatures are used, the ratios of the trivalent titanium ions may be controlled by producing oxygen deficiencies in their crystal structures. Incidentally, the compound $Ae_yTi_8O_{16}$ that is preferred over the others has a hollandite crystal structure, and the structure may be retained when y is not more than 2. In the compound $Ae_yTi_8O_{16}$, the amount of the trivalent titanium ions may be controlled by varying the amount of Ae (y).

The n-type thermoelectric conversion material II has preferably a crystal structure in which the ratio of a distance between a titanium and another titanium nearest the titanium to a distance between the titanium and the alkaline earth metal nearest the titanium ((Ti-Ti)/(Ti-Ae)) is not less than 0.5 and less than 1.0. When the ratio (Ti-Ti)/(Ti-Ae) is less than 1.0, the distance between the titanium atoms are short, and therefore there is a tendency for the n-type thermoelectric conversion material II to increase electric conductivity and as a result to increase figure of merit. The ratio (Ti-Ti)/(Ti-Ae) of, for example, a compound $BaTiO_3$ is as high as 1.14. In contrast, the ratios of, for example, compounds $Ba_yTi_8O_{16}$ (y is from 0.8 to 2 and that range also holds true for the value of y set forth below), $Ba_2Ti_{13}O_{22}$, and $Ba_2Ti_6O_{13}$ are as low as 0.81, 0.83, and 0.76 respectively and therefore preferred. On the other hand, the lower limit of the ratio (Ti-Ti)/(Ti-Ae) is usually about 0.5. Incidentally, distance between, for example, Ti and Ae may be calculated from values obtained by determining the atomic coordinates and lattice constant of the individual atoms by means of, for example, Rietveld analysis.

The n-type thermoelectric conversion material II contains preferably a compound having a one-dimensional tunnel-type crystal structure. The one-dimensional tunnel-type crystal structure is built up of one-dimensional rutile-like chains are formed in which $MO_6$ octahedrons (M is at least one selected from the group consisting of Ti, V, Cr, Mn, Fe, Co, Ni, Cu, Zr, Hf, Sn, Nb, and Wand six oxygen atoms surrounding the atom M) link one after the other with their edges shared, and then the four one-dimensional chains share the vertices of the $MO_6$ octahedrons to form square tunnel spaces. In such a structure, the alkaline earth metal and so on are located in the tunnel spaces. When the n-type thermoelectric conversion material II contains the compound with the one-dimensional tunnel-type crystal structure, the thermal conductivity ($\kappa$) of the n-type thermoelectric conversion material II becomes lower. This may be caused by the contributions of the Ae atoms located in the tunnels to phonon scattering.

Examples of the one-dimensional chain include a single chain where the $MO_6$ octahedrons link together in a row, a double chain where the $MO_6$ octahedrons link together with their edges shared in two rows, and a triple chain where the $MO_6$ octahedrons link together in three rows. The one-dimensional tunnel-type crystal structure in which the tunnel spaces are each surrounded by the four single chains (that is, in which the $MO_6$ octahedrons are formed in one vertical row $\times$ one horizontal row) is called a pyrolusite crystal structure; the one-dimensional tunnel crystal structure in which the tunnel spaces are each surrounded by the two single chains and two double chains (that is, in which the $MO_6$ octahedrons are formed in one vertical row $\times$ two horizontal rows) is called a ramsdellite crystal structure; the one-dimensional tunnel crystal structure in which the tunnel spaces are each surrounded by the four double chains (that is, in which the $MO_6$ octahedrons are formed in two vertical rows $\times$ two horizontal rows) is called a hollandite crystal structure; the one-dimensional tunnel crystal structure in which the tunnel spaces are each surrounded by the two double chains and two triple chains (that is, in which the $MO_6$ octahedrons are formed in two vertical rows $\times$ three horizontal rows) is called a romanechite crystal structure; and the one-dimensional tunnel crystal structure in which the tunnel spaces are each surrounded by the four triple chains (that is, in which the $MO_6$ octahedrons are formed in three vertical rows $\times$ three horizontal rows) is called a todorokite crystal structure. Among others, the compound with a hollandite crystal structure remains stable even at high temperature, and hence a thermoelectric conversion material is preferred which contains the compound with a hollandite crystal structure.

The alkaline earth metal ions contained in the n-type thermoelectric conversion material II may be substituted with heterovalent metal ions such as lithium (Li), potassium (K), sodium (Na), yttrium (Y), lanthanum (La), cerium (Ce), bismuth (Bi), praseodymium (Pr), neodymium (Nd), and samarium (Sm), preferably Na, K, and Bi.

Furthermore, the titanium contained in the n-type thermoelectric conversion material II may be substituted with another element provided that its crystal structure is retained. Examples of the element include vanadium (V), manganese (Mn), chromium (Cr), iron (Fe), cobalt (Co), nickel (Ni), copper (Cu), zinc (Zn), hafnium (Hf), tin (Sn), niobium (Nb), and tungsten (W), preferably V and Mn.

The n-type thermoelectric conversion material II is typically used in the form of a sintered body. When used in such a form, the density of the sintered body is also important. In view of mechanical strength, the sintered body has a relative density of not less than 60 % (for example, in a sintered body $Ba_{1.23}Ti_8O_{16}$ with a theoretical density of 4.24 $g/cm^3$, its relative density is not less than 2.54 $g/cm^3$), more preferably not less than 90 % (in the sintered body $Ba_{1.23}Ti_8O_{16}$ with the theoretical density of 4.24 $g/cm^3$, its relative density is not less than 3.82$g/cm^3$), and further preferably not less than 95 %. On the other hand, when the relative density is less than 60 %, there is a tendency for the electric conductivity (s) to lower. The density of the sintered body may be controlled by adjusting the grain size of the metal compound mixture, the grain size of the calcined powder or the pulverized powder, the molding pressure in the molding step, sintering temperature, sintering time, and so on.

The n-type thermoelectric conversion material II may have an over coating layer which is formed as a surface layer. The over coating layer may intercept oxygen penetrations and therefore formed of, for example, alumina, titania, zirconia, or silicon carbide. Even when the n-type thermoelectric conversion material II having the over coating layer has been exposed to an elevated temperature (for example, 1000°C), the oxidation of trivalent titanium (from trivalent titanium to quadrivalent titanium) contained in the n-type thermoelectric conversion material II is suppressed, and hence high performance is retained.

Further, in terms of an increase in the electric conductivity (s), it is preferable to align the crystallographic axis of the thermoelectric conversion material according to the invention. Examples of the thermoelectric conversion with high orientation include an oriented sintered body and a single crystal.

It is preferable that the n-type thermoelectric conversion material II is used at a temperature of less than 400°C. When used at a temperature of more than 400°C, there is a possibility that its performance deteriorates because trivalent Ti contained in the n-type thermoelectric conversion material II is oxidized (in the case where the over layer is not provided in particular).

The n-type thermoelectric conversion material II is used as one of the components of a thermoelectric conversion module and usually placed in the enclosure of a thermoelectric conversion power generation unit. The enclosure of the unit may be vacuum-sealed or sealed with an inert gas (nitrogen, argon, helium, or the like) filled.

The thermoelectric conversion module usually contains the n-type thermoelectric conversion material II and a p-type thermoelectric conversion material. As such a p-type thermoelectric conversion material, known materials may be used.

A thermoelectric conversion power generation system usually includes the thermoelectric conversion power generation unit and a control unit. The control unit regulates the amount of power generation produced by the thermoelectric conversion power generation system.

PROCESS FOR PRODUCING N-TYPE THERMOELECTRIC CONVERSION MATERIAL II

The n-type thermoelectric conversion material II may be produced by using a method in which, for example, a titanium compound and an alkaline earth metal compound are calcined in a hydrogen-containing atmosphere.

As such a titanium compound, material converted to titania by calcination (titanium metal, titanyl sulfate and the like) or titania is used; titania is preferably used. The titania has a crystal structure of rutile, anatase, or brookite.

As the alkaline earth metal compound, material converted to alkaline earth metal oxide by calcination or alkaline metal oxide is used, and therefore carbonate, sulfide, or oxide of Mg, Ca, Sr, or Ba is used; carbonate of Mg, Ca, Sr, or Ba is preferably used.

The calcination is carried out in a reducing atmosphere. The reducing atmosphere is produced by using, for example, an inert gas (nitrogen, argon, helium, or the like) containing at least 2 vol % of hydrogen and preferably using an inert gas containing at least 30 vol % of hydrogen or hydrogen. By calcining the compounds in the reducing atmosphere, a calcined piece containing trivalent titanium can be obtained. A calcination temperature and calcination time depend on the concentration of the hydrogen gas contained in the atmosphere and are usually between 800° C and 1500° C and between 10 min and 24 hr. After the calcination, it is preferable to keep a calcined piece in the reducing atmosphere until the temperature is preferably lowered to room.

Calcined products may be pulverized. The pulverization may be carried out by using a ball mill, a vibration mill, an attritor, a dynor mill, or the like. By changing the grain size of the pulverized powders, sintered bodies with different densities may be obtained at the sintering step set forth below.

Usually, the powder is molded. The molding can out by, for example, uniaxial pressing, cold isostatic pressing (CIP), mechanical pressing, or the like. The powder is molded into articles with the shape of a prism, a cylinder, or the like in accordance with the shape of a thermoelectric conversion module. By changing molding pressure, sintered body with different densities can be obtained.

In addition, in this molding, spray drying can be combined therewith. Spherical particles several tens of $\mu$m in diameter are obtained by means of the spray drying. By molding the particles, the density of the sintered body obtained at the sintering step set forth below is controlled. Furthermore, in such a molding, substances to be lost during the sintering step (for example, resin beads or walnut powder) may be mixed with the powder. By mixing the substance to be lost during the sintering therewith, sintered body with different pore size may be obtained at the sintering step set forth below.

The resulting green body is usually sintered. The sintering is carried out in an inert atmosphere or a reducing atmosphere. The inert atmosphere is, for example, nitrogen, argon, or helium. The reducing atmosphere is, for example, an inert gas (nitrogen, argon, helium, or the like) containing at least 2 vol % of hydrogen and preferably an inert gas containing at least 30 vol % of hydrogen or hydrogen. The sintering temperature is between 1100°C and 1700°C, and sintering time is between 1 hour and 24 hours. By changing the sintering temperature and the sintering time, it is possible to control density and pore size of the sintered body.

The resulting sintered body may be annealed in air. The annealing may carried out at a temperature between, for example, 600°C and 1000°C. By annealing the sintered body, the durability of the n-type thermoelectric conversion material II may be improved.

After annealing in air, the over coating layer made of alumina, titania, zirconia, or silicon carbide may be formed on the n-type thermoelectric conversion material II by aerosol deposition, flame spraying, or the like.

## EXAMPLES

The following examples further illustrate the present invention; however, the examples are not intended to limit the scope of the invention. The properties were measured as follows.

Electric conductivity:

Test pieces (10 mm $\times$ 3 mm $\times$ 3 mm) were made, platinum wires were fixed to the test pieces by using silver paste, and the electric conductivity of the test pieces was measured by using a direct-current 4-terminal method. The temperatures of the test pieces were controlled by the temperature of a tube furnace. A $N_2$ gas or an Ar gas was introduced into the tube furnace to produce an inert atmosphere.

Seebeck coefficient:

A R-type thermocouple and a platinum wire are connected to both ends of test pieces made by the same method as that used in the measurement of the electric conductivity, the test pieces were put into a tube furnace, and the temperature of the tube furnace was changed. A $N_2$ gas or an Ar gas was introduced into the tube furnace to produce an inert atmosphere. The Seebeck coefficients were calculated from the relationships between the measured thermoelectromotive forces and the temperature differences across the test pieces. A heater or a cooler contact with the one side of the test pieces to make a temperature difference in the test pieces. The temperature difference was made in a range of 1°C to 10°C.

Thermal conductivity:

The thermal conductivity of the test pieces was measured by a laser flash method using a thermal conductivity measuring apparatus ("TC-7000" from ULVAC Inc.).

X-ray diffraction pattern:

The X-ray diffraction patterns of the test pieces were measured by using an X-ray diffraction measuring apparatus ("RINT2500TTR" from Rigaku Corp.).

Density I of sintered body:

The densities of sintered body were calculated from the size and weight of the sintered body.

Density II of sintered body:

The surfaces of sintered body were polished and the polished surfaces were photographed by using a scanning electron microscope. Then the porosity of the sintered body was measured by using a section method based on the obtained microstructure photograph to calculate the densities II of the sintered body.

Oxygen content:

The increased weight of sintered body was measured under the oxygen atmosphere at 1000 ° C for 1 hour with a heating rate of 10 °C/min by using a TG-DTA apparatus (available from MacScience Corp.) to determine the oxygen content (x of the formula (A)).

## N-TYPE THERMOELECTRIC CONVERSION MATERIAL I

### EXAMPLE 1

10 g of a titania (trade name "PT401M", particle diameter: 0.3 $\mu$m, main crystal phase: anatase, manufactured by Ishihara Techno Corp.) was calcined in an atmosphere of 100 % hydrogen at 1000° C for 1 hour to obtain a powder. The powder had peaks at positions of $2\theta$=26.2°, 26.9°, 27.9°, and 28.2° in an X-ray diffraction pattern and no Magneli phase.

The powder was pulverized by using a ball mill (media: 15 mm$\Phi$ zirconia balls) and then molded by using a cold isostatic press (molding pressure: 1 t/cm$^2$) to obtain a pellet (green body). The green body was sintered in an atmosphere of 100 % hydrogen at 1000°C for 1 hour to obtain a sintered body. The sintered body had peaks at positions of $2\theta$=26.2°, 26.9°, 27.9°, and 28.2° in an X-ray diffraction pattern and no Magneli phase. The sintered body contained several % of rutile. In addition, the sintered body had a density of 2.8 g/cm$^3$, a particle diameter (grain size) of about 3 $\mu$m, and an oxygen content x of 1.92 (TiO$_{1.92}$).

The sintered body had a Seebeck coefficient of -144 $\mu$V/K at 300 K, an electric conductivity of $3.4 \times 10^3$ S/m, a thermal conductivity of 0.7 W/mK at room temperature (25°C), and a figure of merit Z of $0.10 \times 10^{-3}$ K$^{-1}$. Further, the sintered body had sufficient mechanical strength and suffered no damage during its machining.

### EXAMPLE 2

Sintered body were produced in the same operation as in Example 1 except that the material i.e., the titania having a particle diameter of 0.4 $\mu$m was used instead of the material having a particle diameter of 0.3 $\mu$m.

The sintered body had peaks at positions of $2\theta$=26.1°, 27.1°, 27.9°, and 28.3° in an X-ray diffraction pattern and no Magneli phase. The sintered body had a density of 2.1 g/cm$^3$, a particle diameter of about 2 $\mu$m, and an oxygen content x of 1.93 (TiO$_{1.93}$). The sintered body had a Seebeck coefficient of -121 $\mu$V/K at 300 K, an electric conductivity of $1.1 \times 10^3$ S/m, a thermal conductivity of 0.1 W/mK, and a figure of merit Z of $0.16 \times 10^{-3}$ K$^{-1}$. Further, the sintered body had sufficient mechanical strength and suffered no damage during its machining.

### EXAMPLE 3

10 g of a titania (trade name: "PT401M", particle diameter: 0.3 pm, manufactured by Ishihara Techno Corp.) was molded by using a cold isostatic press (molding pressure: 1.0 t/cm$^2$) to obtain a green body. The green body was sintered in a nitrogen gas containing 3 vol% of hydrogen at 970° C for 1 hour to obtain a sintered body.

The sintered body had peaks at positions of $2\theta$=26.2°, 26.9°, 28.0°, and 28.1° in an X-ray diffraction pattern and no Magneli phase. The sintered body had a density of 2.8 g/cm$^3$, a particle diameter of 0.5 pm, and an oxygen content x of 1.96 (TiO$_{1.96}$).

The sintered body had a Seebeck coefficient of -135 $\mu$V/K at 300 K, an electric conductivity of $2.4 \times 10^3$ S/m, a thermal conductivity of 0.6 W/mK, and a figure of merit Z of $0.073 \times 10^{-3}$ K$^{-1}$. Further, the sintered body had sufficient mechanical strength and suffered no damage during its machining.

COMPARATIVE EXAMPLE 1

10 g of a titania (trade name "PT401M", particle diameter: 0.3 pm, manufactured by Ishihara Techno Corp.) was molded by using a cold isostatic press (molding pressure: 1.0 t/cm$^2$) to obtain a green body. The green body was sintered in a nitrogen gas containing 100 vol% of hydrogen at 1200° C for 1 hour to obtain a sintered body.

The sintered body had no peaks at positions of 2θ=26.0°±0.3°, 26.8°±0.3°, 27.9°±0.1°, and 28.2°±0.1° in an X-ray diffraction pattern, but had Magneli phase represented as $Ti_5O_9$ (in $TiO_x$, x=1.80). The sintered body had a density of 3.8 g/cm$^3$, a Seebeck coefficient of -67 μV/K at 300 K, an electric conductivity of $1.8 \times 10^3$ S/m, a thermal conductivity of 6.3 W/mK, and a figure of merit Z of $0.013 \times 10^{-3}$ K$^{-1}$.

COMPARATIVE EXAMPLE 2

A sintered body was produced in the same operation as in Example 1 except that the molding pressure was changed to 0.5 t/cm$^2$ and the sintering temperature was changed to 950°. The sintered body had a composition represented by the formula $TiO_{1.94}$ (x=1.94) and a density of 1.7 g/cm$^3$. The sintered body had a Seebeck coefficient of -46 μV/K at 300 K, an electric conductivity of $0.6 \times 10^3$ S/m, a thermal conductivity of 0.09 W/mK, and a figure of merit Z of $0.014 \times 10^{-3}$ K$^{-1}$.

N-TYPE THERMOELECTRIC CONVERSION MATERIAL II

EXAMPLE 4

A titania (trade name "PT401M", particle diameter: 0.3 μm, main crystal phase: anatase, manufactured by Ishihara Techno Corp.) and a barium carbonate (trade name "LC-1", manufactured by Nippon Chemical Industrial Co.) were mixed together for 6 hours by using a ball mill (media: plastic balls, type: dry) to obtain a mixture having a molar ratio of titanium to barium (Ti/Ba) of 6.49. The mixture was calcined in a gas stream of nitrogen containing 2 vol % of hydrogen at 1000°C for 6 hours. The calcined product was pulverized by using a ball mill (media: zirconia balls, type: dry) to obtain a powder. The powder was molded by using a uniaxial press (molding pressure: 200 kg/cm$^2$) and then molded by using a cold isostatic press (molding pressure: 1.5 t/ cm$^2$) to obtain a disc-shaped green body. The green body was placed into a furnace and sintered in a gas stream of 100 % hydrogen at 1300°C for 12 hours to obtain a black sintered body.

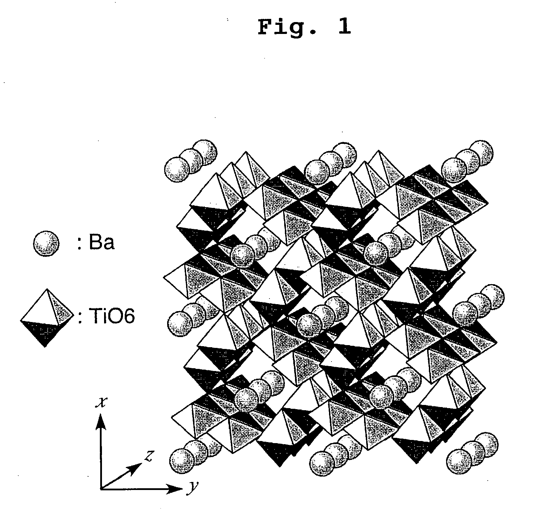

The sintered body of Example 4 had a relative density of 99 % and a crystal structure of $Ba_{1.23}Ti_8O_{16}$ single phase, that is, a compound single phase having a hollandite-type structure (illustrated in Fig. 1) which refers to a one-dimensional tunnel-type crystal structure. In addition, the sintered body of Example 4 had a molar ratio of Ti to Ba of 6.49 and an amount of trivalent titanium ions based on total amount of titanium of 30.8 %.

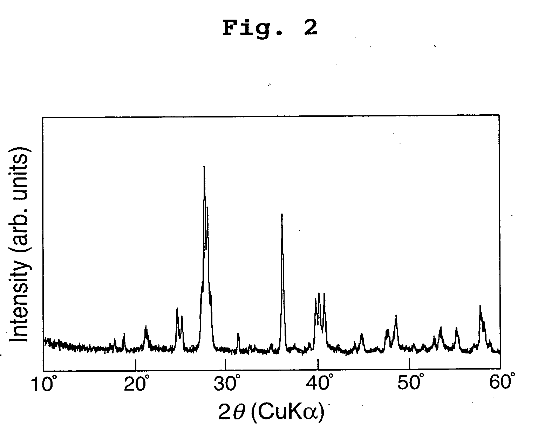

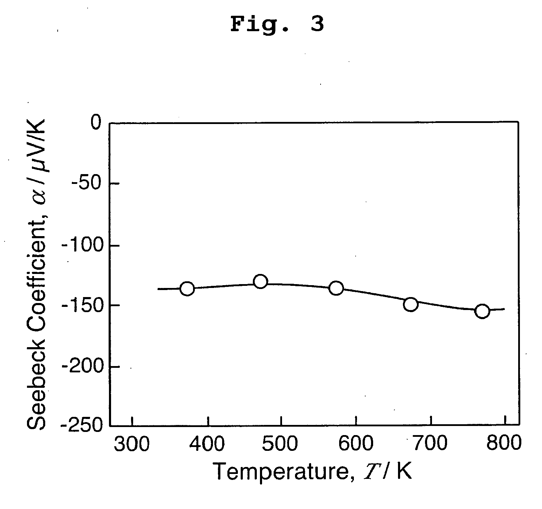

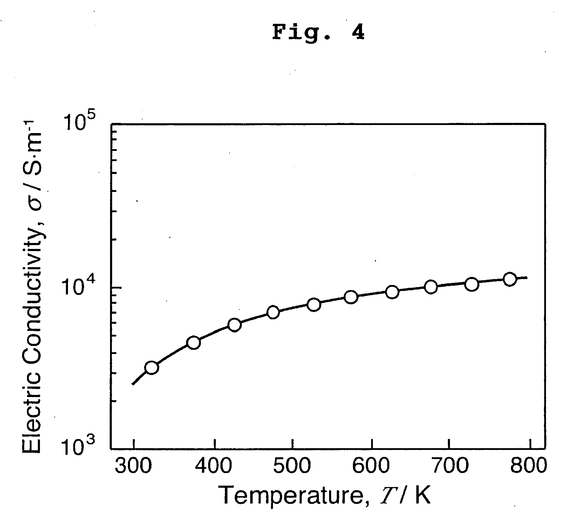

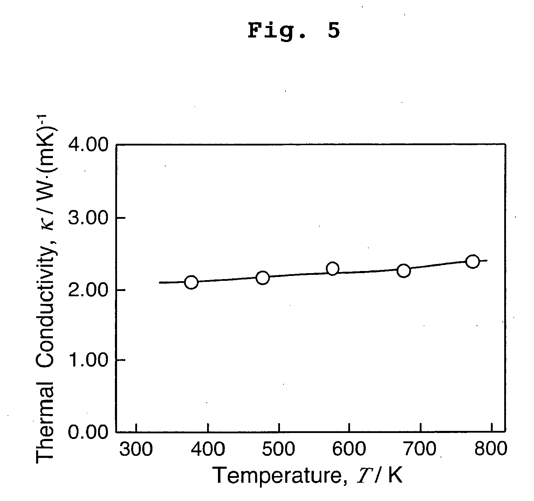

Fig. 2 shows the X-ray diffraction pattern of the sintered body of Example 4; fig. 3 shows the temperature dependence of its Seebeck coefficient; fig. 4 shows the temperature dependence of its electric conductivity; and fig. 5 shows the temperature dependence of its thermal conductivity.

The sintered body of Example 4 had an electric conductivity of $4.66 \times 10^3$ S/m at 100°C and $11.2 \times 10^3$ S/m at 500 °C. The sintered body of Example 4 showed semiconductive behaviors that the electric conductivity increases with increasing temperature. The sintered body had a Seebeck coefficient of -136 μV/K at 100°C and -156 μV/K at 500°C. The Seebeck coefficients of Example 4 thereof had negative signs, and the absolute value of the Seebeck coefficient exceeded 100 μV/K in all the measuring temperature range.

The sintered body had a thermal conductivity of 2.10 W/mK at 100°C and 2. 38 W/mK at 500°C and a figure of merit Z of $0.11 \times 10^{-3}$ K$^{-1}$ at 500°C.

EXAMPLES 5 TO 8

Sintered bodies of Example 5 to 8 were produced in the same operation as in Example 4 except that the ratios of Ti to Ba were changed as shown in Table 1.

When the molar ratios of Ti to Ba were from 6.13 to 8, the sintered bodies had a $Ba_yTi_8O_{16}$ single phase having a hollandite structure. The sintered bodies had relative densities of not less than 95 %.

As shown in Table 2, when the molar ratios of Ti to Ba are from 6.13 to 8, the sintered bodies had electric conductivities of more than $10^3$ S/m. The Seebeck coefficients thereof had negative signs, and the absolute value of the coefficients exceeds 100 μV/K. The thermal conductivities of the sintered bodies are sufficiently low at the molar ratios of Ti to Ba in the range of 6 to 10, and therefore the sintered bodies of Example 5 to 8 are preferred as thermoelectric conversion materials.

EXAMPLES 9 AND 10

Sintered bodies of Example 9 and 10 were produced in the same operation as in Example 4 except that part of Ba was replaced with Sr to change molar ratios of Ti to (Ba+Sr) as shown in Table 1. Strontium carbonate was used as a compound material for Sr.

The sintered body had a crystal structure of hollandite compound single phase and relative densities of not less than 95 %. The thermoelectric properties of the sintered bodies were shown in Table 2.

EXAMPLES 11 AND 12

Sintered bodies of Example 11 and 12 were produced in the same operation as in Example 4 except that part of Ba was replaced with Bi to change molar ratios of Ti to Ba and compositions as shown in Table 1. Bismuth oxide was used as a compound material for Bi.

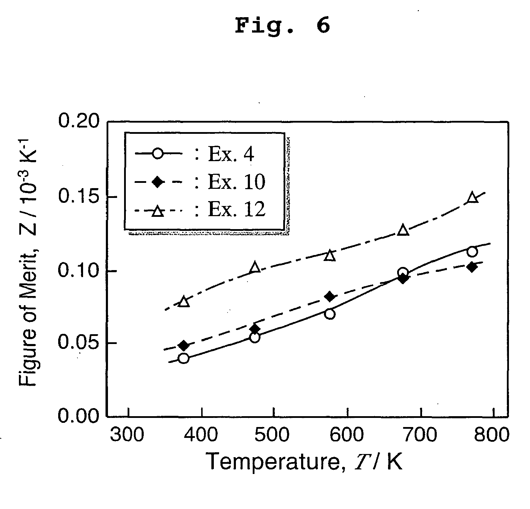

The sintered bodies had a crystal structure of hollandite compound single phase and relative densities of not less than 95 %. The thermoelectric properties of the sintered bodies were shown in Table 2. In addition, the temperature dependence of the figure of merits Z of the sintered bodies obtained in Examples 4, 10, and 12 was shown in Fig. 6.

Table 1

| SINTERING CONDITION, AND MOLAR RATIO Ti/Ae, COMPOSITION, CRYSTAL STRUCTURE OF SINTERED BODY | | | | | |
|---|---|---|---|---|---|
| | SINTERING CONDITION | | SINTERED BODY | | |
| | TEMP. (°C) | ATMOSPHERE | MOLAR RATIO Ti/Ae | COMPOSITION | CRYSTAL STRUCTURE |
| Example 4 | 1300 | 100% HYDROGEN | 6.50 | $Ba_{1.23}Ti_8O_{16}$ | HOLLANDITE TYPE |
| Example 5 | 1300 | 100% HYDROGEN | 10.0 | $Ba_{0.80}Ti_8O_{16}$ | HOLLANDITE TYPE, $Ti_3O_5$ |
| Example 6 | 1300 | 100% HYDROGEN | 8.00 | $Ba_{1.00}Ti_8O_{16}$ | HOLLANDITE TYPE |
| Example 7 | 1300 | 100% HYDROGEN | 6.94 | $Ba_{1.15}Ti_8O_{16}$ | HOLLANDITE TYPE |
| Example 8 | 1300 | 100% HYDROGEN | 6.35 | $Ba_{1.26}Ti_8O_{16}$ | HOLLANDITE TYPE |
| Example 9 | 1300 | 100% HYDROGEN | 6.50 | $Ba_{1.13}Sr_{0.1}Ti_8O_{16}$ | HOLLANDITE TYPE |
| Example 10 | 1300 | 100% HYDROGEN | 6.50 | $Ba_{1.03}Sr_{0.2}Ti_8O_{16}$ | HOLLANDITE TYPE |
| Example 11 | 1300 | 100% HYDROGEN | 7.08 | $Ba_{1.13}Bi_{0.1}Ti_8O_{16}$ | HOLLANDITE TYPE |
| Example 12 | 1300 | 100% HYDROGEN | 7.77 | $Ba_{1.03}Bi_{0.2}Ti_8O_{16}$ | HOLLANDITE TYPE |

Table 2

| THERMOELECTRIC PROPERTIES OF SINTERED BODY | | | | | | | | | |
|---|---|---|---|---|---|---|---|---|---|
| | MOLAR RATIO Ti/Ae | SEEBECK COEFFICIENT a ($\mu$V/K) | | ELECTRIC CONDUCTIVITY s ($\times 10^3$ S/m) | | THERMAL CONDUCTIVITY K (W/mK) | | FIGURE OF MERIT Z ($\times 10^{-3}$ K$^{-1}$) | |
| | | 373K | 773K | 373K | 773K | 373K | 773K | 373K | 773K |
| Example 4 | 6.50 | -136 | -156 | 4.66 | 11.2 | 2.10 | 2.38 | 0.04 | 0.11 |
| Example 5 | 10.0 | -119 | -126 | 5.30 | 14.2 | 2.27 | 2.63 | 0.03 | 0.09 |
| Example 6 | 8.0 | -118 | -137 | 4.03 | 9.56 | 2.20 | 2.73 | 0.03 | 0.07 |
| Example 7 | 6.94 | -137 | -126 | 4.14 | 9.68 | 2.01 | 2.53 | 0.04 | 0.06 |
| Example 8 | 6.35 | -140 | -164 | 4.39 | 10.7 | 2.14 | 2.34 | 0.04 | 0.12 |
| Example 9 | 6.50 | -134 | -148 | 4.73 | 10.9 | 1.77 | 2.19 | 0.05 | 0.11 |
| Example 10 | 6.50 | -144 | -149 | 4.50 | 10.4 | 1.87 | 2.25 | 0.05 | 0.10 |
| Example 11 | 6.50 | -119 | -123 | 5.54 | 12.1 | 1.53 | 1.94 | 0.05 | 0.09 |
| Example 12 | 6.50 | -131 | -139 | 5.88 | 13.3 | 1.28 | 1.70 | 0.08 | 0.15 |

COMPARATIVE EXAMPLE 3

A titania (trade name "PT401M", particle diameter: 0.3 pm, main crystal phase: anatase, manufactured by Ishihara Techno Corp.) and a barium carbonate (trade name "LC-1", manufactured by Nippon Chemical Industrial Co.) were mixed together for 6 hours by using a ball mill (media: plastic balls, type: dry) to obtain a mixture (Ti : Ba=1 mole: 1 mole).

The mixture was calcined in an atmosphere of 100 % hydrogen at 1200° C for 1 hour to obtain a powder. The powder was pulverized in a mortar and molded by using a uniaxial press (molding pressure: 200 kg/cm$^2$) and then by using a cold isostatic press (molding pressure: 1.5 t/cm$^2$) to obtain a disc-shaped green body. The green body was sintered in an atmosphere of 100 % hydrogen at 1400° C for 1 hour to obtain a sintered body. The sintered body had a main crystal phase of $BaTiO_3$ and no trivalent titanium. The electric resistance of the sintered body was too high to measure the Seebeck coefficient thereof.

**Claims**

1. A n-type thermoelectric conversion material comprising a titanium oxide represented by the formula (A)

$$TiO_x \qquad (A)$$

wherein 1.89=x<1.94 or 1.94<x<2.00, and the n-type thermoelectric conversion material has peaks at positions of 2θ=26.0°±0.3°, 26.8°±0.3°, 27.9°±0.1°, and 28.2°±0.1° in an X-ray diffraction pattern measured under the conditions :

    X-ray source: CuKa,
    tube current: 140 mA,
    tube voltage: 40 kV, and

step width: 0.02°.

2. The n-type thermoelectric conversion material according to claim 1, further comprising an over coating layer.

3. The n-type thermoelectric conversion material according to claim 2, wherein the over coating layer is oxygen impermeable barrier.

4. The n-type thermoelectric conversion material according to claim 2, wherein the over coating layer is made of at least one selected from the group consisting of alumina, titania, zirconia and silicon carbide.

5. A process for producing a n-type thermoelectric conversion material, comprising the steps of:

   calcining a titanium compound in a hydrogen-containing atmosphere under the following conditions to obtain a powder,
   in case of a hydrogen concentration of not less than 1 vol % and less than 5 vol % (balance inert gas):
   Calcination Temperature: 1000°C to 1400°C,
   Calcination Time: 1 hr to 10 hours,
   in case of a hydrogen concentration of not less than 5 vol % and not more than 100 vol % (balance inert gas):
   Calcination Temperature: 950°C to 1050°C,
   Calcination Time: 10 min to 5 hours,
   molding the powder, and,
   sintering the resultant.

6. A process for producing a n-type thermoelectric conversion material, comprising the steps of:

   molding a titanium compound,
   sintering the resultant in a hydrogen-containing atmosphere
   under the following conditions to obtain a powder,
   in case of a hydrogen concentration of not less than 1 vol % and less than 5 vol % (balance inert gas):
   Sintering Temperature: 1000°C to 1400°C,
   Sintering Time: 1 hr to 10 hours,
   in case of a hydrogen concentration of not less than 5 vol % and not more than 100 vol % (balance inert gas):
   Sintering Temperature: 950°C to 1050°C,
   Sintering Time: 10 min to 5 hours.

7. The process according to claim 5 or 6, wherein the titanium compound is at least one selected from the group consisting of titanyl sulfate and titania.

8. The process according to claim 5 or 6, further comprising the step of annealing the sintered body.

9. The process according to claim 5 or 6, further comprising the step of forming an over coating layer on the sintering body.

10. The process according to claim 5 or 6, wherein the forming of an over coating layer is carried out by at least one selected from the group consisting of aerosol deposition and flame spraying.

11. A n-type thermoelectric conversion material comprising a compound containing an alkaline earth metal, a titanium, and an oxygen, wherein at least one part of the titanium are ions of trivalent titanium, and the following conditions (a) to (c) are satisfied:

   (a) the molar ratio of titanium (Ti) to the alkaline earth metal (Ae) is not less than 2,
   (b) one-dimensional chains are formed in which octahedrons each composed of the titanium and the six oxygens surrounding the titanium link together with their vertices and/or edges, and/or faces shared, and
   (c) the one-dimensional chains gather in the units of at least four pieces with part of the vertices of the octahedrons shared such that the compound is contained which has a one-dimensional tunnel crystal structure in which tunnel spaces surrounded by the at least four-dimensional chains are formed.

12. The n-type thermoelectric conversion material according to claim 11, comprising a crystal structure in which the ratio of a distance between a titanium and another titanium nearest the titanium to a distance between the titanium and the alkaline earth metal nearest the titanium ((Ti-Ti)/(Ti-Ae)) is not less than 0.5 and less than 1.0.

13. The n-type thermoelectric conversion material according to claim 11, wherein the compound containing an alkaline earth metal, a titanium, and an oxygen is at least one selected from the group consisting of $BaTiO_3$, $Ba_2Ti_{13}O_{22}$, $Ba_yTi_8O_{16}$ (0.8 $\leqq$y$\leqq$2), $BaTi_7O_{14}$, $Ba_2Ti_6O_{13}$, and $Sr_2Ti_6O_{13}$.

14. The n-type thermoelectric conversion material according to claim 11, further comprising a relative density of not less than 60%.

15. The n-type thermoelectric conversion material according to claim 11, further comprising an over coating layer as a surface layer.

16. The n-type thermoelectric conversion material according to claim 15, wherein the over layer is oxygen impermeable barrier.

17. The n-type thermoelectric conversion material according to claim 15, wherein the over layer is made of at least one selected from the group consisting of alumina, titania, zirconia, and silicon carbide.

18. A process for producing a n-type thermoelectric conversion material comprising the steps of:

calcining a titanium compound and an alkaline earth metal compound in a reducing atmosphere at a temperature of 900° C to 1400°C to obtain a powder,
molding the powder, and
sintering the resultant in an inert gas atmosphere or a reducing atmosphere at a temperature of 1100° C to 1700°C.

19. The process according to claim 18, further comprising the step of annealing the sintered body.

20. The process according to claim 18, further comprising the step of forming an over coating layer on the sintered body.

21. The process according to claim 20, wherein the forming an over layer is carried out by at least one selected from the group consisting of aerosol deposition and flame spraying.

22. A thermoelectric conversion module comprising the n-type thermoelectric conversion material according to any of claims 1 to 4 and 11 to 17, and a p-type thermoelectric conversion material.

23. A thermoelectric conversion power generation system comprising the thermoelectric conversion unit according to claim 22 and a control unit.

Fig. 1

○ : Ba

◇ : TiO6

# Fig. 2

Fig. 3

Fig. 4

# Fig. 5

# Fig. 6

**INTERNATIONAL SEARCH REPORT**

| International application No. |
|---|
| PCT/JP2005/013897 |

A. CLASSIFICATION OF SUBJECT MATTER
*H01L35/22* (2006.01), *C04B35/46* (2006.01), *C04B41/87* (2006.01),
*H01L35/34* (2006.01)

According to International Patent Classification (IPC) or to both national classification and IPC

B. FIELDS SEARCHED

Minimum documentation searched (classification system followed by classification symbols)
*H01L35/22* (2006.01), *C04B35/46* (2006.01), *C04B41/87* (2006.01),
*H01L35/34* (2006.01)

Documentation searched other than minimum documentation to the extent that such documents are included in the fields searched
Jitsuyo Shinan Koho          1922-1996      Jitsuyo Shinan Toroku Koho      1996-2005
Kokai Jitsuyo Shinan Koho    1971-2005      Toroku Jitsuyo Shinan Koho      1994-2005

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 54-114090 A  (Mitsuteru KIMURA),<br>05 September, 1979 (05.09.79),<br>Full text<br>(Family: none) | 1,5-8,22-23<br>2-4,9-10 |
| X<br>Y | Isao TSUYUMOTO, "Atarashii Futeihi Sanka Titan o Riyo shita Netsuden Henkan Soshi no Kaihatsu", Research Projects in Review, Nissan Science Foundation, 26, 2003, full text | 1,5-8,22-23<br>2-4,9-10 |
| X<br>Y | Isao TSUYUMOTO, "Atarashii Futeihi Sanka Titan no Sosei to Thermochromic Tokusei no Seigyo", Research Projects in Review, Nissan Science Foundation, 25, 2002, pages 145 to 148 | 1,5-8,22-23<br>2-4,9-10 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>07 October, 2005 (07.10.05) | Date of mailing of the international search report<br>25 October, 2005 (25.10.05) |
|---|---|
| Name and mailing address of the ISA/<br>Japanese Patent Office | Authorized officer |
| Facsimile No. | Telephone No. |

Form PCT/ISA/210 (second sheet) (January 2004)

**INTERNATIONAL SEARCH REPORT**

| International application No. |
|---|
| PCT/JP2005/013897 |

C (Continuation).   DOCUMENTS CONSIDERED TO BE RELEVANT

| Category* | Citation of document, with indication, where appropriate, of the relevant passages | Relevant to claim No. |
|---|---|---|
| X<br>Y | I. TSUYUMOTO, New orthorhombic titanium oxide, TiO1.94, Journal of Materials Science Letters, 19, 2000, pages 2075 to 2076 | 1,5-8,22-23<br>2-4,9-10 |
| P,X | Isao TSUYUMOTO, Monstoichiometric orthorhombic titanium oxide, TiO2-d and its thermochromic properties, Materials Research Bulletin, Vol.39, Issue 11, 01 September, 2004 (01.09.04), pages 1737 to 1744 | 1,5-8,22-23 |
| X<br>Y | Isao TSUYUMOTO, "Shitsuon no Jido Chosetsu o Mezashita Thermochromic Zairyo – Atarashii Futeihi Sanka Titan no Sosei to Hyoka –", Dai 10 Kai Intelligent Materials Symposium Koen Yoshishu, 15 March, 2001 (15.03.01), pages 54 to 55 | 1,5-8,22-23<br>2-4,9-10 |
| X<br>Y | Isao TSUYUMOTO, "Atarashii Shaho Shosanka Titan no Denkiteki Seishitsu to Thermochromism", The Ceramic Society of Japan Dai 14 Kai Shuki Symposium Koen Yokoshu, 26 September, 2001 (26.09.01), page 215 | 1,5-8,22-23<br>2-4,9-10 |
| X<br>Y | Isao TSUYUMOTO, "Atarashii Shaho Shosanka Titan TiO1.94 no Kozo to Bussei", The Ceramic Society of Japan Dai 13 Kai Shuki Symposium Koen Yoshishu, 11 October, 2000 (11.10.00), page 255 | 1,5-8,22-23<br>2-4,9-10 |
| Y | JP 6-229837 A  (Sumitomo Electric Industries, Ltd.),<br>19 August, 1994 (19.08.94),<br>Full text<br>(Family: none) | 2-4,9-10,<br>15-17,20-21 |
| Y | JP 2001-119076 A  (Matsushita Electric Works, Ltd.),<br>27 April, 2001 (27.04.01),<br>Full text<br>& US 6274803 B1 | 2-4,9-10,<br>15-17,20-21 |
| Y | JP 2003-012327 A  (National Institute of Advanced Industrial Science and Technology),<br>15 January, 2003 (15.01.03),<br>Full text<br>(Family: none) | 11-23 |
| Y | JP 2003-188425 A  (NEC Corp.),<br>04 July, 2003 (04.07.03),<br>Full text<br>(Family: none) | 11-23 |

Form PCT/ISA/210 (continuation of second sheet) (January 2004)

**INTERNATIONAL SEARCH REPORT**

| International application No. |
| --- |
| PCT/JP2005/013897 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2003-179272 A  (Toyota Central Research And Development Laboratories, Inc.), 27 June, 2003 (27.06.03), Full text (Family: none) | 11-23 |
| Y | JP 62-235298 A  (Director General of National Institute for Research in Inorganic Materials of Science and Technology Agency), 15 October, 1987 (15.10.87), Full text (Family: none) | 11-23 |
| Y | JP 2000-178026 A  (Kubota Corp.), 27 June, 2000 (27.06.00), Full text (Family: none) | 11-23 |
| Y | JP 62-041176 B2  (Director General of National Institute for Research in Inorganic Materials of Science and Technology Agency), 01 September, 1987 (01.09.87), Full text (Family: none) | 11-23 |
| Y | JP 5-198847 A  (Matsushita Electric Industrial Co., Ltd.), 06 August, 1993 (06.08.93), Full text & US 5275001 A | 18-21 |

Form PCT/ISA/210 (continuation of second sheet) (January 2004)

## INTERNATIONAL SEARCH REPORT

| International application No. |
| --- |
| PCT/JP2005/013897 |

---

**Box No. II**      **Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

---

**Box No. III**      **Observations where unity of invention is lacking (Continuation of item 3 of first sheet)**

This International Searching Authority found multiple inventions in this international application, as follows:

    See extra sheet.

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**      ☐ The additional search fees were accompanied by the applicant's protest.

     ☒ No protest accompanied the payment of additional search fees.

---

Form PCT/ISA/210 (continuation of first sheet (2)) (January 2004)

**INTERNATIONAL SEARCH REPORT**

| International application No. |
|---|
| PCT/JP2005/013897 |

Continuation of Box No.III of continuation of first sheet(2)

The requirement of unity of invention (PCT Rule 13.1) in international applications as prescribed in PCT Rule 13.2 is satisfied only when among a group of inventions claimed, there is a technical relationship involving one or more of the same or corresponding special technical features (technical features indicating a contribution by the inventions as a whole over the prior art).

In this application, a technical feature common to the invention of claims 1-4, the invention of claims 5-10, the invention of claims 11-17 and the invention of claims 18-21 is an "n-type thermoelectric conversion material containing a titanium compound".

This "n-type thermoelectric conversion material containing a titanium compound" is described in the reference (1): JP 05-198847 A (Matsushita Electric Industrial Co., Ltd.), 06 August, 1993 (06.08.93), claim 1, Par. Nos. [0025]-[0026], [0049] and the reference (2): JP 2003-012327 A (National Institute of Advanced Industrial Science and Technology (AIST)), 15 January, 2003 (15.01.03), claim 4, Fig. 2.

Consequently, it appears that the above "n-type thermoelectric conversion material containing a titanium compound" was a technical feature publicly known at the time of filing of this international application. Thus, the feature does not signify a technology contributory over the prior art and cannot be recognized as being a special technical feature prescribed in the above rule.

Moreover, among the above inventions, it does not appear that there are other same or corresponding special technical features (in this connection, it does not appear that the invention of claims 5-10 is directed to a method particularly applied for production of the product of claim 1).

As apparent from the above, in this application, it cannot be contended that among the above inventions, there exist same or corresponding special technical features. Therefore, the inventions claimed in this international application do not satisfy the requirement of unity of invention prescribed in PCT Rule 13.1.

Form PCT/ISA/210 (extra sheet) (January 2004)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8231223 A

**Non-patent literature cited in the description**

- *Study Report by the Nissan Chemical Industries Development Foundation,* 2003, vol. 26